(19) Europäisches Patentamt
European Patent Office
Office européen des brevets

(11) **EP 0 626 761 B1**

(12) **EUROPÄISCHE PATENTSCHRIFT**

(45) Veröffentlichungstag und Bekanntmachung des Hinweises auf die Patenterteilung:
**05.02.1997 Patentblatt 1997/06**

(51) Int Cl.6: **H03L 7/07**, G06F 1/12

(21) Anmeldenummer: **93108531.0**

(22) Anmeldetag: **26.05.1993**

(54) **Anordnung zur Synchronisation zweier getaktet arbeitender Geräte**

Arrangement for synchronising two clocked apparatuses

Dispositif de synchronisation de deux appareils cadencés

(84) Benannte Vertragsstaaten:
**AT BE CH DE DK ES FR GB IT LI NL SE**

(43) Veröffentlichungstag der Anmeldung:
**30.11.1994 Patentblatt 1994/48**

(73) Patentinhaber: **SIEMENS AKTIENGESELLSCHAFT**
**80333 München (DE)**

(72) Erfinder: **Korbacher, Richard, Dipl.-Ing.**
**W-8039 Puchheim (DE)**

(56) Entgegenhaltungen:
- **THE NATIONAL TELESYSTEMS CONFERENCE; CONFERENCE RECORD 7. November 1982, GALVESTON, TEXAS Seiten E2.1.1 - E2.1.5 W.C. LINDSEY U.A. 'MUTUAL SYNCHRONIZATION OF TWO OSCILLATORS'**
- **IBM TECHNICAL DISCLOSURE BULLETIN. Bd. 23, Nr. 7A, Dezember 1980, NEW YORK US Seiten 2924 - 2926 R. P. CHRISFIELD U.A. 'PHASE-LOCKED CLOCKING'**
- **IEEE TRANSACTIONS ON COMMUNICATIONS Bd. 30, Nr. 10, Oktober 1982, NEW YORK US Seiten 2344 - 2354 TADAO SAITO 'APPLICATION OF PHASE-LOCKED OSCILLATOR FOR PCM NETWORK SYNCHRONIZATION'**

**Beschreibung**

Die Erfindung betrifft eine Anordnung zur Synchronisation zweier getaktet arbeitender Geräte.

Um den Gleichlauf Zweier Geräte zu erreichen, gibt es prinzipiell zwei Möglichkeiten, nämlich zum einen die zentrale Synchronisation und zum anderen die gegenseitige Synchronisation.

Bei der zentralen Synchronisation werden die beiden genannten Geräte von einer zentralen Taktquelle synchronisiert (Master-Slave-Synchronisation, z.B. in nachrichtentechnischen Übertragungsnetzen realisiert). Durch gleich lange Signalwege von der zentralen Taktquelle zu den Geräten kann ein nahezu beliebig naher Phasengleichlauf erreicht werden. Ein Nachteil dieser Methode ist die Abhängigkeit von einer zentralen Taktquelle, wodurch sich die Ausfallwahrscheinlichkeit des Gesamtsystems drastisch erhöht.

Bei der gegenseitigen Synchronisation arbeitet das eine Gerät mit einem intern erzeugten freilaufenden Takt, der im folgenden als Muttertakt bezeichnet wird. Eine aus diesem Muttertakt abgeleitete Synchronisationsinformation wird auf das andere Gerät übertragen. Das andere Gerät erzeugt daraus, z.B. mittels Nachlaufsynchronisation (PLL) einen zweiten Takt, der zum Muttertakt frequenzgleich, aber im allgemeinen phasenverschoben ist. Diese Phasenverschiebung ist abhängig von der Signallaufzeit des Muttertaktsignal zwischen den beiden Geräten und den Eigenschaften der in den Geräten befindlichen Phasenregelkreise. Durch geeignete Kompensationsschaltungen kann die Phasenverschiebung für eine feste Signallaufzeit zwischen den beiden Geräten minimiert werden. Bei der Anwendung von solchen Kompensationsschaltungen ergibt sich der Nachteil, daß für eine exakte Synchronisation die Kompensationsschaltung abhängig von der Signallaufzeit eingestellt werden muß.

Aus The National Telesystems Conference, 7. Nov. 1982, Conference Record, Seiten E2.1.1 bis E2.1.5, W.C. Lindsey u.a. "Mutual Synchronization of two Oscillators" ist eine Anordnung nach dem Oberbegriff des Anspruchs 1 bekannt.

Der Erfindung liegt die Aufgabe zugrunde, eine phasenidentische gegenseitige Synchronisation zu ermöglichen, ohne daß ein Abgleich oder ein Kalibrieren von Schaltungsteilen notwendig ist.

Diese Aufgabe wird durch eine Anordnung gemäß Anspruch 1 gelöst.

Eine weitere Ausführungsform der Erfindung ist durch Anspruch 2 angegeben. Bei dieser Ausführungsform wird das führende erste Taktsignal dem ersten Gerät nicht extern zugeführt, sondern intern erzeugt.

Eine weitere Ausführungsform der Erfindung ist durch Anspruch 3 angegeben. Diese Ausführungsform betrifft den Fall der gegenseitigen Synchronisation. Sie hat den Vorteil, daß beide Geräte identisch aufgebaut sind, jedes der Geräte für sich allein asynchron betrieben werden kann und dennoch die Synchronisation jederzeit während des Betriebs ohne Phasensprünge oder sonstige Störungen möglich ist.

Im folgenden wird die Erfindung anhand der Zeichnung näher erläutert.

Figur 1 zeigt eine spezielle Ausführungsform der erfindungsgemäßen Anordnung.

Figur 2 zeigt den internen Aufbau eines Schleifenfilters.

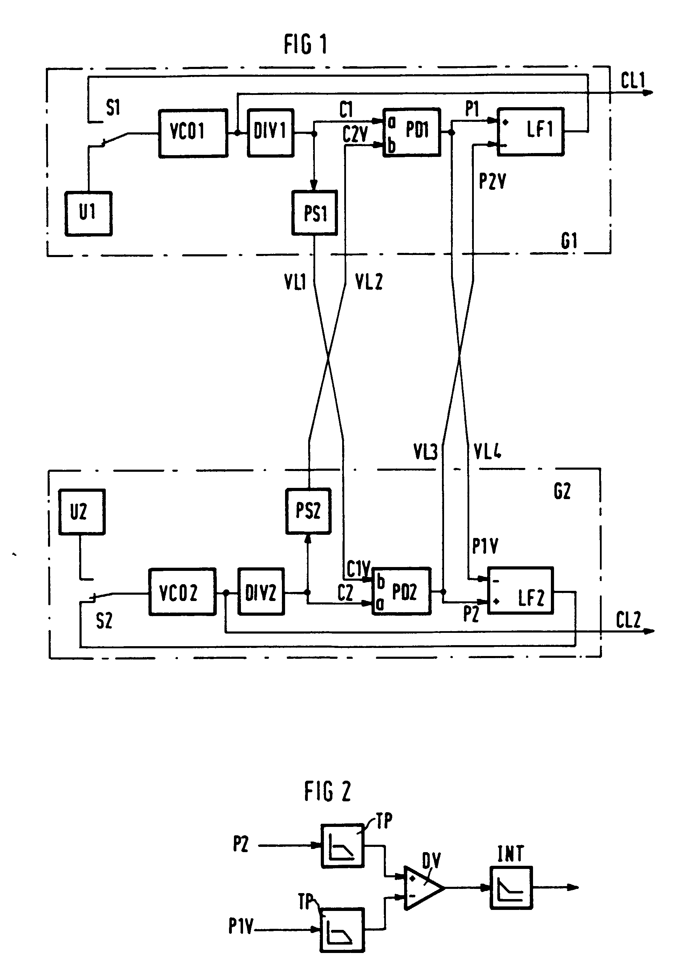

In der Figur 1 ist durch entsprechende Schalterstellung eines ersten Schalters S1 dargestellt, daß in einem ersten Gerät G1 der Muttertakt erzeugt wird, auf den sich das zweite Gerät G2 synchroniseren soll. Die umgekehrte Synchronisationsrichtung ist durch entsprechendes Umschalten ebenso möglich, sogar während des Betriebs der beiden Geräte.

In beiden Geräten ist die Takterzeugung identisch aufgebaut, nämlich aus einem spannungsgesteuerten Oszillator $VCO_1$ ($VCO_2$), einem Frequenzteiler $DIV_1$ ($DIV_2$), einem Phasenvergleicher $PD_1$ ($PD_2$), einem Schleifenfilter $LF_1$ ($LF_2$), einem Phasenschieber $PS_1$ ($PS_2$), einer Konstantspannungsquelle $U_1$ ($U_2$) und einem Schalter $S_1$ ($S_2$).

Im ersten Gerät G1 wird ein erstes Taktsignal CL1, nämlich das Muttertaktsignal, erzeugt. Dazu wird der spannungsgesteuerte Oszillator $VCO_1$ über den ersten Schalter S1 mit der ersten Konstantspannungsquelle U1 verbunden.

Aus dem ersten Taktsignal CL1 wird über den ersten Teiler DIV1 das normierte erste Taktsignal C1 des Phasenregelkreises abgeleitet. Das Teilerverhältnis kann prinzipiell frei gewählt werden, jedoch soll die Periodendauer des normierten ersten Taktsignals C1 wesentlich größer als die Signallaufzeit zwischen beiden Geräten sein.

Ein Verbindungskabel zur Realisierung der Verbindungsstruktur zwischen den beiden Geräten umfaßt vier Verbindungsleitungen, die die Signale C1, C2, P1 und P2 führen. Von diesen Verbindungsleitungen müssen die beiden Verbindungsleitungen VL1 und VL2 die gleiche Signallaufzeit bzw. die gleiche Länge aufweisen.

Das normierte erste Taktsignal C1 wird einerseits dem eigenen Phasenvergleicher PD1 und andererseits über einen Phasenschieber PS1 und die Verbindungsleitung VL1 dem zweiten Phasenvergleicher PD2 im zweiten Gerät G2 zugeführt. Der Phasenschieber ist nicht nötig, wenn der Phasenvergleicher so ausgelegt ist, daß er im geschlossenen Phasenregelkreis auf Phasengleichheit regelt.

Im allgemeinen muß die Phasenverschiebung durch den zweiten Phasenschieber PS2 auf denjenigen Wert eingestellt werden, der sich beim verwendeten Phasenvergleicher in einen Phasenregelkreis zweiten Grades mit aktivem Schleifenfilter einstellt (z. B. 90° bei EXOR).

Es können verschiedene Typen von Phasenvergleichern, d. h. auch solche mit analogem Ausgang verwendet werden. Bei der weiteren Beschreibung des Schleifenfilters wird davon ausgegangen, daß die Ausgangssignale PD1 und PD2 Digitalsignale darstellen, deren Pulsbreite zu der gemessenen Phasendifferenz am Eingang der Phasenvergleicher proportional ist.

Figur 2 zeigt das Prinzipschaltbild des zweiten Schleifenfilters LF2 im zweiten Gerät G2, wobei der erste Schleifenfilter LF1 im ersten Gerät G1 hinsichtlich seiner Struktur identisch aufgebaut ist. Dem zweiten Schleifenfilter LF2 werden die digitalen Ausgangspulse P2 des zweiten Phasenvergleichers PD2 und das um die Signallaufzeit verzögerte Ausgangssignal P1V des ersten Phasenvergleichers PD1 zugeführt. Im Schleifenfilter werden die beiden Eingangssignale P2 und P1V zunächst digital-analog gewandelt und gleichzeitig tiefpaßgefiltert (in Figur 2 durch einen Tiefpaß TP dargestellt), und dann über einen Differenzverstärker DV einem Integrator INT zugeführt. Das Ausgangssignal des Integrators liefert den Stellwert für den zweiten spannungsgesteuerten Oszillator VCO2.

Während des Einschwingvorganges der gegenseitigen Synchronisation versucht der geschlossene Phasenregelkreis im zweiten Gerät G2 den zweiten spannungsgesteuerten Oszillator VCO2 so einzustellen, daß die Differenz der Ausgangssignale P2 und P1V gleich Null wird und somit die gemessenen Phasendifferenzen zwischen den normierten Taktsignalen C1 und C2V sowie zwischen den normierten Taktsignalen C2 und C1V gleich groß werden. Durch den Integrator im Schleifenfilter stellt sich diese Gleichheit der Phasendifferenzen im eingeschwungenen Zustand ein.

Durch folgende einfache Rechnung läßt sich zeigen, daß die Phasendifferenz zwischen den normierten Taktsignalen C1 und C2 im eingeschwungenen Zustand gleich der halben Differenz der Laufzeiten über die Verbindungsleitungen VL1 und VL2 ist:

$$\left.\begin{aligned} \varphi_{C1V}(t) &= \varphi_{C1}(t) - \varphi_{VL1} \\ \varphi_{C2V}(t) &= \varphi_{C2}(t) - \varphi_{VL2} \\ \varphi_{C2}(t) - \varphi_{C1V}(t) &= \varphi_{C1}(t) - \varphi_{C2V}(t) \end{aligned}\right\} \Rightarrow \varphi_{C2}(t) - \varphi_{C1}(t) = \frac{\varphi_{VL2} - \varphi_{VL1}}{2}$$

Da die beiden Verbindungsleitungen VL1 und VL2 gleich lang ausgeführt werden, wird die Phasendifferenz zwischen den normierten Taktsignalen C1 und C2 und damit auch die Phasendifferenz zwischen den beiden Taktsignalen CL1 und CL2 zu Null.

Die Laufzeiten über die Verbindungsleitungen VL3 und VL4 wirken sich nur als zusätzliche Totzeit im Phasenregelkreis aus. Dies kann im allgemeinen vernachlässigt werden, da bei üblicher Dimensionierung des Phasenregelkreises die Zeitkonstante des Tiefpasses im Schleifenfilter wesentlich größer als die Laufzeit über die Verbindungsleitungen ist.

**Patentansprüche**

1. Anordnung zur Synchronisation zweier getaktet arbeitender Geräte, mit

 a) einem ersten Phasenvergleicher (PD1) im ersten Gerät (G1), an dessen einem Eingang (a) das führende erste Taktsignal (C1) zugeführt ist,
 b) einem Phasenregelkreis im zweiten Gerät (G2), der ein bezüglich des ersten Taktsignales synchrones zweites Taktsignal (C2) erzeugt, wobei der Phasenregelkreis ein Schleifenfilter (LF2) umfaßt, und wobei der Phasenregelkreis einen zweiten Phasenvergleicher (PD2) umfaßt,
 c) einer Verbindungsstruktur zwischen dem ersten und zweiten Gerät mit

  c1) einer ersten Leitung (VL1), die das erste Taktsignal dem zweiten Eingang (b) des zweiten Phasenvergleichers zuführt,
  c2) einer zweiten Leitung (VL2), die das zweite Taktsignal dem zweiten Eingang des ersten Phasenvergleichers zuführt, wobei die Längen der ersten und zweiten Leitung identisch sind,

**dadurch gekennzeichnet,** daß

 d) das genannte Schleifenfilter (LF2) an seinem Eingang mit Hilfe eines Differenzverstärkers (DV) einen invertierenden und einen nichtinvertierenden Eingang aufweist, wobei sich an den genannten Differenzverstärker (DV) ein Filterglied (INT) mit integrierender Charakteristik anschließt,
 e) das Ausgangssignal des zweiten Phasenvergleichers (PD2) dem nichtinvertierenden Eingang des Differenzverstärkers (DV) zugeführt ist, und

f) eine dritte Leitung (VL4) das Ausgangssignal des ersten Phasenvergleichers dem invertierenden Eingang des Differenzverstärkers (DV) zuführt.

**2.** Anordnung zur Synchronisation gemäß Anspruch 1,
**dadurch gekennzeichnet,**
daß das erste Gerät (G1) einen Taktgenerator (VCO1) umfaßt, der das erste Taktsignal (C1) erzeugt.

**3.** Anordnung gemäß Anspruch 2,
**dadurch gekennzeichnet**,
daß

a) das erste Gerät (G1) einen zu dem zweiten Gerät (G2) identischen Phasenregelkreis umfaßt, wobei der Betrieb eines jeweiligen Phaenregelkreises über einen entsprechenden Schalter (S1, S2) sowohl als Taktgenerator (Phasenregelkreis offen), als auch als nachlaufender Phasenregelkreis (Phasenregelkreis geschlossen) eingestellt werden kann,
b) die genannte Verbindungsstruktur zwischen dem ersten und zweiten Gerät um eine vierte Leitung (VL3) erweitert ist, die das Ausgangssignal (P2) des zweiten Phasenvergleichers (PD2) dem invertierenden Eingang des Schleifenfilters (LF1) des Phasenregelkreises des ersten Gerätes zuführt.

## Claims

1. Arrangement for synchronizing two clocked devices, having

   a) a first phase comparator (PD1) in the first device (G1), to one input (a) of which the leading first clock signal (C1) is fed,
   b) a phase locked loop in the second device (G2), which generates a second clock signal (C2) which is synchronous with respect to the first clock signal, the phase locked loop comprising a loop filter (LF2), and the phase locked loop comprising a second phase comparator (PD2),
   c) a connecting structure between the first and second devices, having

      c1) a first line (VL1) which feeds the first clock signal to the second input (b) of the second phase comparator, and
      c2) a second line (VL2), which feeds the second clock signal to the second input of the first phase comparator, the lengths of the first and second lines being identical,

   characterized

   d) in that with the aid of a differential amplifier (DV) the said loop filter (LF2) has at its input an inverting and a non-inverting input, a filter element (INT) with an integrating characteristic being connectea to the said differential amplifier (DV),
   e) in that the output signal of the second phase comparator (PD2) is fed to the non-inverting input of the differential amplifier (DV), and
   f) in that a third line (VL4) leads the output signal of the first phase comparator to the inverting input of the differential amplifier (DV).

2. Arrangement for synchronizing in accordance with Claim 1, characterized in that the first device (G1) comprises a clock generator (VCO1) which generates the first clock signal (C1).

3. Arrangement according to Claim 2, characterized

   a) in that the first device (G1) comprises a phase locked loop identical to the second device (G2), it being possible to set the operation of a respective phase locked loop via a corresponding switch (S1, S2) both as a clock generator (phase locked loop open) and as a tracking phase locked loop (phase locked loop closed), and
   b) in that the said connecting structure between the first and second devices is extended by a fourth line (VL3) which feeds the output signal (P2) of the second phase comparator (PD2) to the inverting input of the loop filter (LF1) of the phase locked loop of the first device.

**EP 0 626 761 B1**

**Revendications**

1. Dispositif de synchronisation de deux appareils fonctionnant de manière cadencée, comportant

   a) dans le premier appareil (G1), un premier comparateur de phase (PD1) à une entrée (a) duquel est envoyé le premier signal de cadence directeur (C1),
   b) dans le second appareil (G2), une boucle à verrouillage de phase qui produit un second signal de cadence (C2) en synchronisme avec le premier signal de cadence, la boucle à verrouillage de phase comprenant un filtre de boucle (LF2) et la boucle à verrouillage de phase comprenant un second comparateur de phase (PD2),
   c) une structure de liaison entre le premier appareil et le second appareil comportant

   c1) une première ligne (VL1) qui conduit le premier signal de cadence à la seconde entrée (b) du second comparateur de phase,
   c2) une seconde ligne (VL2) qui conduit le second signal de cadence à la seconde entrée du premier comparateur de phase, les longueurs de la première ligne et de la seconde ligne étant égales,

   caractérisé par le fait que

   d) ledit filtre de boucle (LF2) a à son entrée, à l'aide d'un amplificateur différentiel (DV), une entrée inverseuse et une entrée non inverseuse, un élément de filtrage (INT) à caractéristique intégrante se raccordant audit amplificateur différentiel (DV),
   e) le signal de sortie du second comparateur de phase (PD2) est envoyé à l'entrée non inverseuse de l'amplificateur différentiel (DV), et
   f) une troisième ligne (VL4) conduit le signal de sortie du premier comparateur de phase à l'entrée inverseuse de l'amplificateur différentiel (DV).

2. Dispositif de synchronisation selon la revendication 1,
   caractérisé par le fait que le premier appareil (G1) comprend un générateur de cadence (VCO1) qui produit le premier signal de cadence (C1).

3. Dispositif selon la revendication 2,
   caractérisé par le fait que

   a) le premier appareil (G1) comprend une boucle à verrouillage de phase identique à celle du second appareil (G2), le fonctionnement de chaque boucle à verrouillage de phase pouvant être réglé par l'intermédiaire d'un commutateur correspondant (S1, S2) aussi bien comme générateur de cadence (boucle à verrouillage de phase ouverte) que comme boucle à verrouillage de phase asservie (boucle à verrouillage de phase fermée),
   b) ladite structure de liaison entre le premier appareil et le second appareil est complétée par une quatrième ligne (VL3) qui conduit le signal de sortie (P2) du second comparateur de phase (PD2) à l'entrée inverseuse du filtre de boucle (LF1) de la boucle à verrouillage de phase du premier appareil.

## FIG 1

## FIG 2